# EUROPEAN PATENT APPLICATION

(11) **EP 2 423 973 A1**
(43) Date of publication of application: **29.02.2012**
(21) Application number: 10766992.1
(22) Date of filing: 14.04.2010
(51) Int. Cl.: H01L 31/042

(54) **WIRING SHEET, SOLAR CELL PROVIDED WITH WIRING SHEET, AND SOLAR CELL MODULE**

(30) Priority: 23.04.2009 JP 2009105442
(71) Applicant: Sharp Kabushiki Kaisha, Osaka-shi, Osaka 545-8522 (JP)
(72) Inventor: NAKAMURA, Moritaka, Osaka 545-8522 (JP)
(74) Representative: Müller-Boré & Partner Patentanwälte
(86) International application number: PCT/JP2010/056692
(87) International publication number: WO 2010/122935

(57) **Abstract**

A wiring sheet (10) in accordance with the present invention is a wiring sheet (10) having wirings provided on an insulating base material (11) for electrically connecting back surface electrode type solar cells (20) each having first conductivity type electrodes (24) and second conductivity type electrodes (25) arranged on one surface of a semiconductor substrate (21), wherein a cell arrangement portion (19) located at at least one of both ends of cell arrangement portions (19) aligned in a second direction on the insulating base material (11) and a cell arrangement portion (19) adjacent to that cell arrangement portion (19) in a first direction are arranged such that a first conductivity type wiring (12) in one cell arrangement portion (19) and a second conductivity type wiring (13) in the other cell arrangement portion (19) are adjacent to each other in the first direction, and one of combinations of the wirings having different conductivity types is electrically connected between said one cell arrangement portion (19) and said other cell arrangement portion (19).

## Description

### TECHNICAL FIELD

The present invention relates to a wiring sheet, wiring sheet-equipped solar cells, and a solar cell module.

### BACKGROUND ART

A solar cell module such as a solar panel is manufactured by connecting a plurality of solar cells. In a conventional solar cell module, all of solar cells are connected in series by connecting interconnectors connected to the solar cells.

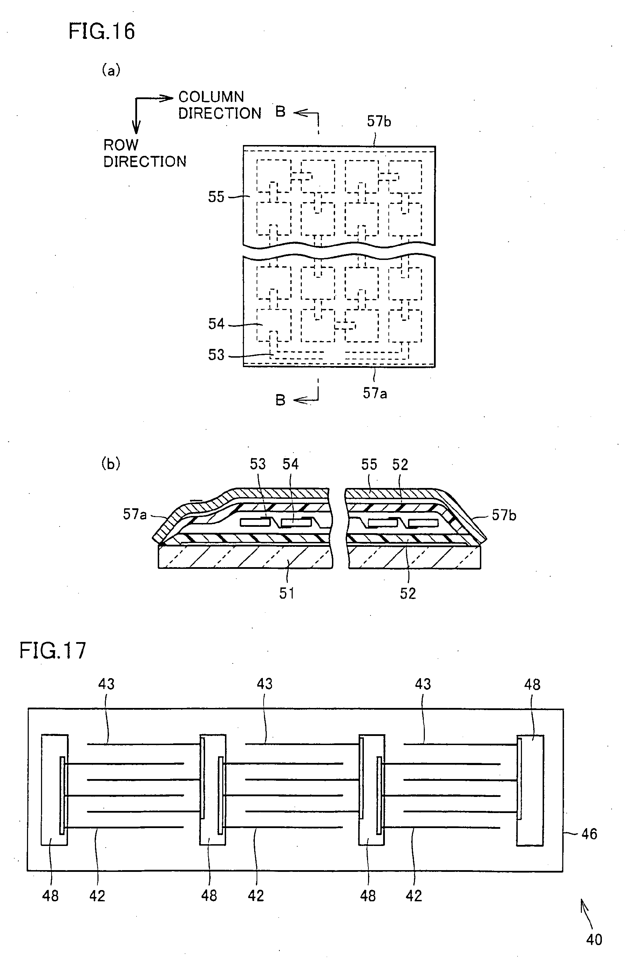

For example, Japanese Patent Laying-Open No. 60-42854 (Patent Literature 1) discloses a solar cell module having a plurality of crystalline solar cells connected by interconnectors. Fig. 16(a) is a schematic view showing a state where solar cells are temporarily bonded in manufacturing a solar panel, and Fig. 16(b) is a view schematically showing a cross section taken in a direction along B-B in Fig. 16(a). As shown in Figs. 16(a) and 16(b), solar cells 54 connected such that a front surface of one solar cell and a back surface of another solar cell are connected by an interconnector 53 are covered with an upper transparent protective material 51 and a lower substrate protective material 55, each with a filling adhesive sheet 52 interposed therebetween. Then, an opposite side portion 57a and an opposite side portion 57b are temporarily bonded. Thereafter, degassing, heating, and pressure bonding are performed on the entire protective materials to attach filling adhesive sheets 52 to solar cell 54, and thus a solar panel is manufactured.

Further, Japanese Patent Laying-Open No. 2005-11869 (Patent Literature 2) and Japanese Patent Laying-Open No. 2005-191479 (Patent Literature 3) disclose a method of connecting back surface electrode type solar cells each having both p-type electrodes and n-type electrodes provided on a back surface, via interconnectors. In these patent literatures, the solar cells are connected one by one by the interconnectors, and aligned in required rows (generally in a row direction) and columns (generally in a column direction), and then the columns are also connected by interconnectors, forming a solar cell module generally all connected by series connection (parallel connection may also be used).

Furthermore, Japanese Patent Laying-Open No. 2005-340362 (Patent Literature 4) discloses a method of arranging back surface electrode type solar cells on a wiring sheet and electrically connecting the solar cells by the wiring sheet in a solar string having a plurality of solar cells connected in series in one column as shown in Fig. 17.

### CITATION LIST

### PATENT LITERATURE

PTL 1: Japanese Patent Laying-Open No. 60-42854
PTL 2: Japanese Patent Laying-Open No. 2005-11869
PTL 3: Japanese Patent Laying-Open No. 2005-191479
PTL 4: Japanese Patent Laying-Open No. 2005-340362

### SUMMARY OF INVENTION

### TECHNICAL PROBLEM

In a case where cells each having electrodes with different polarities provided on respective surfaces thereof are aligned in a matrix as shown in Fig. 16(a) as in the solar cell module disclosed in Patent Literature 1, in order to connect solar cells 54 adjacent to each other in the row direction, it has been necessary to align solar cells 54 with upper and lower surfaces of some solar cells 54 being turned over as shown for example in Fig. 16(b).

Further, for a solar cell module using a wiring sheet as disclosed in Patent Literature 4 with a configuration in which solar cells are aligned in a matrix, a connection configuration therefor has not been established at present.

The present invention has been made in view of the aforementioned situation, and one object of the present invention is to provide a wiring sheet for a solar cell module having adjacent back surface electrode type solar cells connected in series, in which all of the solar cells constituting the solar cell module have an identical electrode alignment pattern and the solar cells can be connected in series in a state aligned on the wiring sheet in an identical direction, as well as a solar cell module.

### SOLUTION TO PROBLEM

A wiring sheet in accordance with the present invention is a wiring sheet having wirings provided on an insulating base material for electrically connecting back surface electrode type solar cells each having first conductivity type electrodes and second conductivity type electrodes arranged on one surface of a semiconductor substrate, wherein the wirings have a cell arrangement portion on which the back surface electrode type solar cell is to be arranged, and a plurality of the cell arrangement portions are aligned on the insulating base material in a first direction and in a second direction different from the first direction, each of the cell arrangement portions includes an alternate alignment portion in which a first conductivity type wiring for the first conductivity type electrodes and a second conductivity type wiring for the second conductivity type electrodes electrically insulated from each other are alternately aligned along the first direction, and the first conductivity type wiring is arranged at one of both ends of the alternate alignment portion in the first direction and the second conductivity type wiring is arranged at the other end, the first conductivity type wiring in one of the cell arrangement portions adjacent to each other in the second direction on the insulating base material is electrically connected with the second conductivity type wiring in the other cell arrangement portion, and the cell arrangement portion located at at least one of both ends of the cell arrangement portions aligned in the second direction on the insulating base material and the cell arrangement portion adjacent to that cell arrangement portion in the first direction are arranged such that the first conductivity type wiring in one cell arrangement portion and the second conductivity type wiring in the other cell arrangement portion are adjacent to each other in the first direction, and one of combinations of the wirings having different conductivity types is electrically connected between the one cell arrangement portion and the other cell arrangement portion.

The present invention relates to the wiring sheet described above having the back surface electrode type solar cells electrically connected thereto. The present invention relates to a solar cell module including any wiring sheet described above.

Wiring sheet-equipped solar cells in accordance with the present invention relate to wiring sheet-equipped solar cells, including: back surface electrode type solar cells each having first conductivity type electrodes and second conductivity type electrodes arranged on one surface of a semiconductor substrate; and a wiring sheet having wirings provided on an insulating base material for electrically connecting the back surface electrode type solar cells, wherein the back surface electrode type solar cells are aligned on the wiring sheet in a first direction and in a second direction different from the first direction, the wirings include an alternate alignment portion in which a first conductivity type wiring electrically connected to the first conductivity type electrodes and a second conductivity type wiring electrically connected to the second conductivity type electrodes of the back surface electrode type solar cell are alternately aligned along the first direction corresponding to each of the back surface electrode type solar cells, the first conductivity type wiring is arranged at one of both ends of the alternate alignment portion in the first direction and the second conductivity type wiring is arranged at the other end, the first conductivity type wiring connected to the first conductivity type electrodes of one of the back surface electrode type solar cells adjacent to each other in the second direction is electrically connected with the second conductivity type wiring connected to the second conductivity type electrodes of the other back surface electrode type solar cell, and, in the wirings to which the back surface electrode type solar cell located at at least one of both ends in the second direction is connected and the wirings connected to the electrodes of the back surface electrode type solar cell adjacent to that back surface electrode type solar cell in the first direction, the wirings adjacent to each other in the first direction have different conductivity types, and one of combinations of the wirings having different conductivity types is electrically connected.

The present invention relates to a solar cell module including the wiring sheet-equipped solar cells described above.

### ADVANTAGEOUS EFFECTS OF INVENTION

According to the wiring sheet in accordance with the present invention, in forming a solar cell module having combined solar cells, the solar cells having an identical electrode pattern can be always aligned in a constant direction in a process of manufacturing the solar cell module. Therefore, manufacturing efficiency of the solar cell module can be improved.

### BRIEF DESCRIPTION OF DRAWINGS

Fig. 1 is a schematic plan view of one example of wiring sheet-equipped solar cells in accordance with the present invention, when viewed from a light-receiving surface side.
Fig. 2 is a schematic view showing an arrangement relation between back surface electrode type solar cells and a wiring sheet in accordance with the present invention.
Fig. 3 is a schematic cross sectional view of one example of the back surface electrode type solar cell shown in Figs. 1 and 2.
Fig. 4(a) is a schematic plan view of one example of a back surface of a semiconductor substrate of the back surface electrode type solar cell shown in Fig. 3, and Fig. 4(b) is a schematic plan view of another example of the back surface of the semiconductor substrate of the back surface electrode type solar cell shown in Fig. 3.
Fig. 5 is a schematic plan view of another example of the back surface of the semiconductor substrate of the back surface electrode type solar cell shown in Fig. 3.
Fig. 6 is a schematic plan view illustrating a method of establishing electrical connection between electrodes of the back surface electrode type solar cell and a composite in the wiring sheet, in accordance with the present invention.
Fig. 7 is a view schematically showing a state of electrically connecting the wiring sheet and the back surface electrode type solar cell, with a cross section taken in a direction along VII-VII in Fig. 6, in accordance with the present invention.
Fig. 8 is a schematic perspective view illustrating one example of a manufacturing method for the wiring sheet-equipped solar cells shown in Fig. 1.
Fig. 9 is a schematic plan view of a shape of wiring materials of a wiring sheet in accordance with Embodiment 1.
Fig. 10 is a schematic plan view enlarging a portion of the wiring materials of the wiring sheet shown in Fig. 9.
Fig. 11 is a schematic plan view of a shape of wiring materials of a wiring sheet in accordance with Embodiment 2.
Fig. 12 is a schematic plan view enlarging a portion of the wiring materials of the wiring sheet shown in Fig. 11.
Fig. 13 is a schematic plan view of a shape of wiring materials of a wiring sheet in accordance with Embodiment 3.
Fig. 14 is a schematic plan view enlarging a portion of the wiring materials of the wiring sheet shown in Fig. 13.
Figs. 15(a) and 15(b) are schematic cross sectional views illustrating one example of a manufacturing method for one example of a solar cell module in accordance with the present invention.
Fig. 16(a) is a schematic view showing a state where solar cells are temporarily bonded in manufacturing a conventional solar panel, and Fig. 16(b) is a view schematically showing a cross section taken in a direction along B-B in Fig. 16(a).
Fig. 17 is a schematic plan view of a conventional wiring sheet composed of one column.

### DESCRIPTION OF EMBODIMENTS

Hereinafter, embodiments of the present invention will be described. It is to be noted that, in the drawings of the present invention, identical or corresponding parts will be designated by the same reference numerals. Further, a configuration in which one or a plurality of cell arrangement portions each for installing a solar cell (i.e., a region on a wiring sheet where a solar cell is to be installed) are aligned will be described below as a wiring sheet, and a configuration in which one or a plurality of solar cells are aligned in a matrix in a first direction and in a second direction different from the first direction will be described below as wiring sheet-equipped solar cells.

In the present invention, examples of the first direction and the second direction described above include a case where the first direction and the second direction are orthogonal to each other so that the alignment in a matrix has the shape of a rectangle, and a case where the first direction and the second direction intersect with each other so that the alignment in a matrix has the shape of a parallelogram or a rhombus. In addition, the specific directions described above are not limited to linear directions, and a case where solar cells are aligned along a portion of an arc is also included. Thus, in the present invention, the first direction and the second direction described above are not particularly limited, and it is satisfactory as long as they have a relation in which straight lines along respective directions intersect with each other. Further, it is satisfactory as long as the shape of a rectangle, a parallelogram, or the like described above is included in a portion of a wiring sheet. For example, a case where both the shape of a rectangle and the shape of a parallelogram are included, and a case where a portion of these shapes are included singularly or in combination are also included in the mode of the present invention as long as adjacent cells form a specific electrical connection using wirings as described later.

### <Embodiment 1>

### (Wiring Sheet-Equipped Solar Cells)

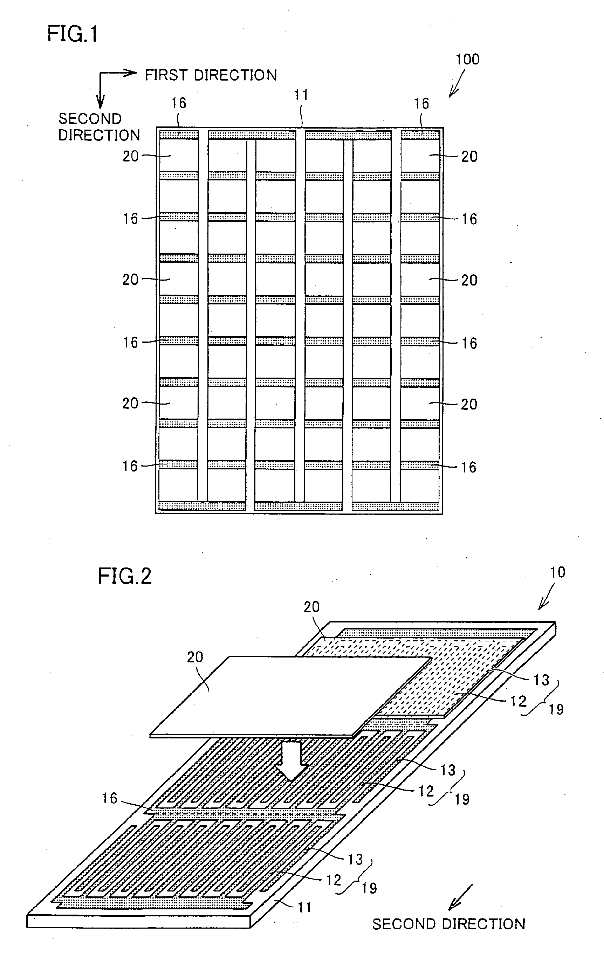

Fig. 1 shows a schematic plan view of one example of wiring sheet-equipped solar cells in accordance with the present invention, when viewed from a light-receiving surface side. Here, wiring sheet-equipped solar cells 100 are composed of a plurality of back surface electrode type solar cells 20 electrically connected by wiring materials 16 on a front surface of an insulating base material 11. By wiring materials 16 provided on the front surface of insulating base material 11, a wiring sheet has a configuration in which a plurality of cell arrangement portions on which the solar cells are to be arranged are aligned in each of a first direction and a second direction different from the first direction. It is to be noted that, although the first direction and the second direction are orthogonal to each other in Fig. 1, the first direction and the second direction are not necessarily orthogonal to each other, as described above. Further, if the first direction and the second direction are orthogonal to each other in this manner, the first direction can also be expressed as a column direction, and the second direction can also be expressed as a row direction.

In wiring sheet-equipped solar cells 100 shown in Fig. 1 having a configuration as described above, the plurality of back surface electrode type solar cells 20 are intended to be electrically connected in series on the front surface of insulating base material 11 such that an energizing path serpentines.

Fig. 2 shows an arrangement relation between the back surface electrode type solar cells and the wiring sheet described above. Fig. 2 corresponds to a portion of a column of the wiring sheet-equipped solar cells shown in Fig. 1. As shown in Fig. 2, wirings made of wiring materials 16 of a wiring sheet 10 include a first conductivity type wiring 12 and a second conductivity type wiring 13 insulated from each other in each cell arrangement portion. The first conductivity type wiring 12 is a wiring to which first conductivity type electrodes of the back surface electrode type solar cell described later are to be connected, and the second conductivity type wiring 13 is a wiring to which second conductivity type electrodes thereof are to be connected. In the present invention, an alternate alignment portion in which the first conductivity type wiring 12 and the second conductivity type wiring 13 are alternately aligned along the first direction is included. In Fig. 2, the first conductivity type wiring 12 and the second conductivity type wiring 13 are each arranged such that portions equivalent to comb teeth of the first conductivity type wiring 12 and portions equivalent to comb teeth of the second conductivity type wiring 13 alternately engage with each other, one by one. As a result, there is formed the alternate alignment portion in which the portions equivalent to the comb teeth of the comb-shaped first conductivity type wiring 12 and the portions equivalent to the comb teeth of the comb-shaped second conductivity type wiring 13 are alternately arranged, one by one, with a predetermined interval provided therebetween. Further, in the present invention, the first conductivity type wiring 12 is arranged at one of both ends of the alternate alignment portion along the first direction and the second conductivity type wiring 13 is arranged at the other end.

On the front surface of insulating base material 11 of wiring sheet 10, cell arrangement portions 19 are aligned in one direction in the front surface of insulating base material 11. Each cell arrangement portion 19 is composed of a combination of one first conductivity type wiring 12 and one second conductivity type wiring 13, and in each cell arrangement portion 19, the portions equivalent to the comb teeth are arranged to engage with each other, with the predetermined interval provided therebetween. Here, Fig. 2 shows a portion of the wiring sheet-equipped solar cells shown in Fig. 1, and the portion includes three cell arrangement portions 19. However, the present invention is not limited thereto, and cell arrangement portion 19 may be electrically connected with another cell arrangement portion 19 arranged adjacent thereto on the front surface of insulating base material 11, as shown in Fig. 1. That is, the present invention is **characterized in that** the cell arrangement portions are arranged such that the first conductivity type wiring 12 in one cell arrangement portion 19 and the second conductivity type wiring 13 in the other cell arrangement portion 19 are adjacent to each other, and one of combinations of the wirings having different conductivity types is electrically connected between one cell arrangement portion 19 and the other cell arrangement portion 19.

By installing back surface electrode type solar cells 20 on a front surface of wiring sheet 10 having the configuration shown in Fig. 2, the wiring sheet-equipped solar cells shown in Fig. 1 can be fabricated.

### (Back Surface Electrode Type Solar Cell)

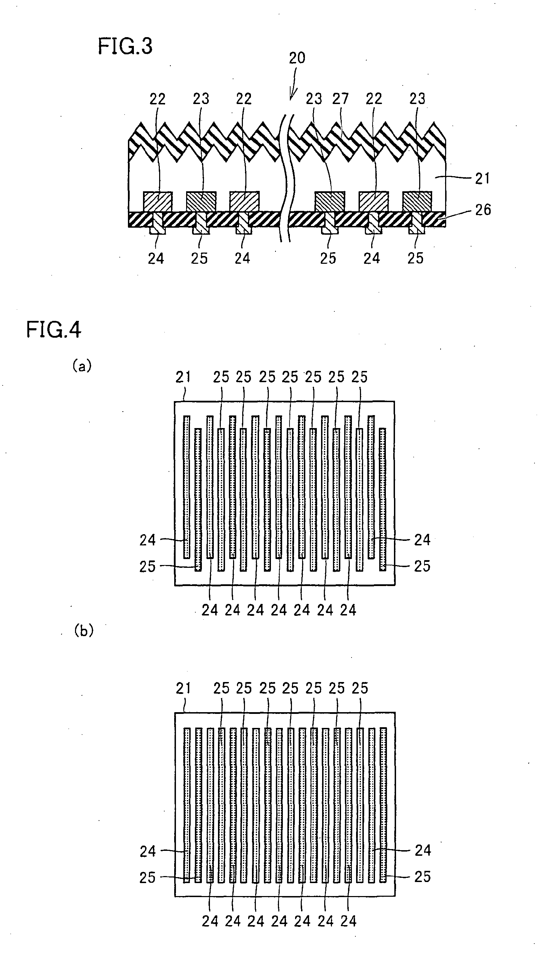

Fig. 3 shows a schematic cross sectional view of one example of back surface electrode type solar cell 20 shown in Figs. 1 and 2. Back surface electrode type solar cell 20 shown in Fig. 3 has a semiconductor substrate 21 such as a silicon substrate having n or p conductivity type, an anti-reflection film 27 formed on an uneven front surface of semiconductor substrate 21 serving as a light-receiving surface of back surface electrode type solar cell 20, and a passivation film 26 formed on a back surface of semiconductor substrate 21 serving as a back surface of back surface electrode type solar cell 20.

Further, in the back surface of semiconductor substrate 21, first conductivity type impurities-diffused regions 22 formed by diffusion of first conductivity type impurities and second conductivity type impurities-diffused regions 23 formed by diffusion of second conductivity type impurities are alternately formed with a predetermined interval provided therebetween. First conductivity type electrodes 24 and second conductivity type electrodes 25 in contact with the first conductivity type impurities-diffused regions 22 and the second conductivity type impurities-diffused regions 23, respectively, through contact holes provided in passivation film 26 on the back surface of semiconductor substrate 21 are provided. If the first conductivity type or the second conductivity type is p type, for example, phosphorus or the like can be used as impurities. If the first conductivity type or the second conductivity type is n type, for example, boron or the like can be used as impurities.

Here, in the back surface of semiconductor substrate 21 having n or p conductivity type, a plurality of pn junctions are formed at interfaces between the first conductivity type impurities-diffused regions 22 or the second conductivity type impurities-diffused regions 23 and the inside of semiconductor substrate 21. Even if semiconductor substrate 21 has any of n and p conductivity type, the first conductivity type impurities-diffused regions 22 and the second conductivity type impurities-diffused regions 23 are each joined to the inside of semiconductor substrate 21. Thus, the first conductivity type electrodes 24 and the second conductivity type electrodes 25 serve as electrodes respectively corresponding to the plurality of pn junctions formed in the back surface of semiconductor substrate 21. It is to be noted that a pn junction may be formed by contact between the first conductivity type impurities-diffused region 22 and the second conductivity type impurities-diffused region 23 close to each other, irrespective of the conductivity type of semiconductor substrate 21.

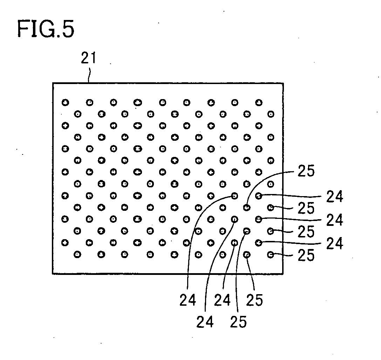

Other configurations of shapes and arrangements of the first conductivity type electrodes 24 and the second conductivity type electrodes 25 on the back surface of back surface electrode type solar cell 20 will be described with reference to Figs. 4(a), 4(b), and 5. Here, the shapes and arrangements of the first conductivity type electrodes 24 and the second conductivity type electrodes 25 on the back surface of back surface electrode type solar cell 20 are not limited to configurations shown in Figs. 4(a), 4(b), and 5, and any shape and arrangement may be employed as long as the first conductivity type electrodes 24 and the second conductivity type electrodes 25 can be electrically connected to the first conductivity type wiring 12 and the second conductivity type wiring 13, respectively, of wiring sheet 10.

Fig. 4(a) shows a schematic plan view of one example of the back surface of semiconductor substrate 21 of back surface electrode type solar cell 20 shown in Fig. 3. As shown in Fig. 4(a), the first conductivity type electrodes 24 and the second conductivity type electrodes 25 are each formed in the shape of strips extending in an identical direction, and alternately arranged, one by one, in a direction orthogonal to the extending direction described above on the back surface of semiconductor substrate 21. The alternately arranged second conductivity type electrodes and first conductivity type electrodes may be arranged to have irregularities in a length direction of the strips as shown in Fig. 4(a), or may be arranged such that both ends of the strips are aligned as shown in Fig. 4(b) as a schematic plan view of another example of the back surface of semiconductor substrate 21 of back surface electrode type solar cell 20 shown in Fig. 3.

Fig. 5 shows a schematic plan view of still another example of the back surface of semiconductor substrate 21 of back surface electrode type solar cell 20 shown in Fig. 3. Here, as shown in Fig. 5, the first conductivity type electrodes 24 and the second conductivity type electrodes 25 are each formed in the shape of dots, and columns of the dot-shaped first conductivity type electrodes 24 (extending in an up-down direction in Fig. 5) and columns of the dot-shaped second conductivity type electrodes 25 (extending in the up-down direction in Fig. 5) are alternately arranged, one by one, in a direction orthogonal to the extending direction described above on the back surface of semiconductor substrate 21.

Further, for example, an electrically conductive material including at least one selected from the group consisting of nickel (Ni), gold (Au), platinum (Pt), palladium (Pd), silver (Ag), tin (Sn), SnPb solder, and indium tin oxide (ITO) may be installed on at least a portion of surfaces of the first conductivity type electrodes 24 and/or at least a portion of surfaces of the second conductivity type electrodes 25 of back surface electrode type solar cell 20. In this case, there are tendencies that a good electrical connection can be established between wiring materials 16 of wiring sheet 10 and the electrodes of back surface electrode type solar cell 20 (the first conductivity type electrodes 24, the second conductivity type electrodes 25), and that weather resistance of the electrodes of back surface electrode type solar cell 20 (the first conductivity type electrodes 24, the second conductivity type electrodes 25) can be improved.

Furthermore, at least a portion of the surfaces of the first conductivity type electrodes 24 and/or at least a portion of the surfaces of the second conductivity type electrodes 25 of back surface electrode type solar cell 20 may be subjected to surface treatment such as blackening treatment.

In addition, as semiconductor substrate 21, for example, a silicon substrate made of such as polycrystalline silicon or monocrystalline silicon having n or p conductivity type, or the like can be used.

As each of the first conductivity type electrodes 24 and the second conductivity type electrodes 25, for example, an electrode made of a metal such as silver can be used.

As passivation film 26, for example, a silicon oxide film, a silicon nitride film, a laminate of a silicon oxide film and a silicon nitride film, or the like can be used.

As anti-reflection film 27, for example, a silicon nitride film or the like can be used.

It is to be noted that the concept of the back surface electrode type solar cell in accordance with the present invention not only includes a solar cell having a configuration in which both the first conductivity type electrodes 24 and the second conductivity type electrodes 25 are formed on only one surface (the back surface) of semiconductor substrate 21 described above, but also includes all of so-called back contact type solar cells (i.e., solar cells having a structure in which current is extracted from a back surface opposite to a light-receiving surface of a solar cell) such as a Metal Wrap Through (MWT) cell (i.e., a solar cell having a configuration in which a portion of each electrode is arranged in a through hole provided in a semiconductor substrate).

Further, the concept of the solar cell in accordance with the present invention is not limited to the back surface electrode type solar cell, but also includes a double surface electrode type solar cell having electrodes on each of the light-receiving surface and the back surface of semiconductor substrate 21 described above.

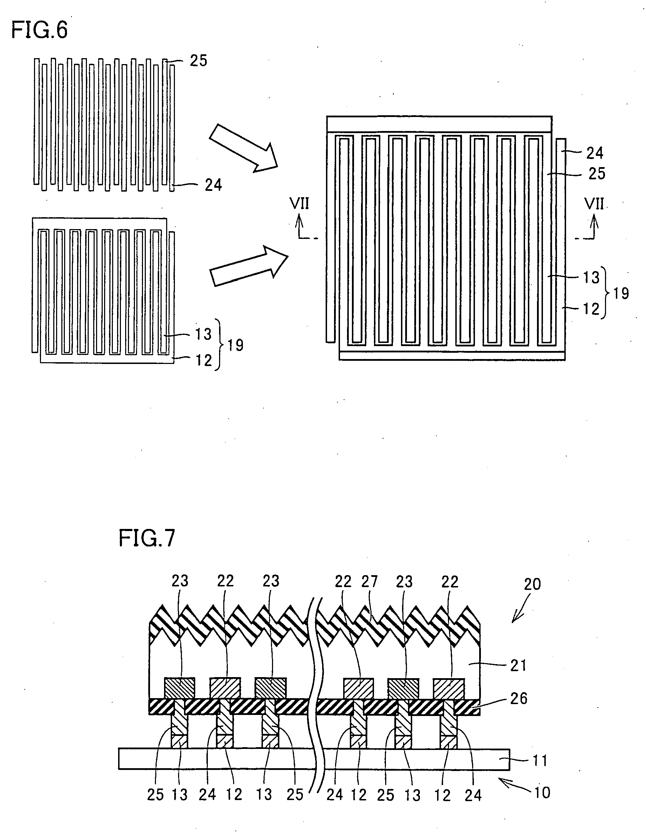

The first conductivity type electrodes 24 and the second conductivity type electrodes 25 of back surface electrode type solar cell 20 described above are each electrically connected to cell arrangement portion 19 as a combination of one first conductivity type wiring 12 and one second conductivity type wiring 13 of wiring sheet 10, as shown for example in a schematic plan view in Fig. 6 and a schematic cross sectional view in Fig. 7. It is to be noted that Fig. 7 is a view schematically showing a state of electrically connecting wiring sheet 10 and back surface electrode type solar cell 20, with a cross section taken in a direction along VII-VII in Fig. 6.

Specifically, as shown in Figs. 6 and 7, portions equivalent to comb teeth of the first conductivity type electrodes 24 of back surface electrode type solar cell 20 overlap with the portions equivalent to the comb teeth of the first conductivity type wiring 12 of wiring sheet 10 and are connected thereto, and portions equivalent to comb teeth of the second conductivity type electrodes 25 of back surface electrode type solar cell 20 overlap with the portions equivalent to the comb teeth of the second conductivity type wiring 13 of wiring sheet 10 and are connected thereto. Thereby, wiring sheet-equipped solar cells 100 shown in Fig. 1 are fabricated.

### (Method of Manufacturing Wiring Sheet-Equipped Solar Cells)

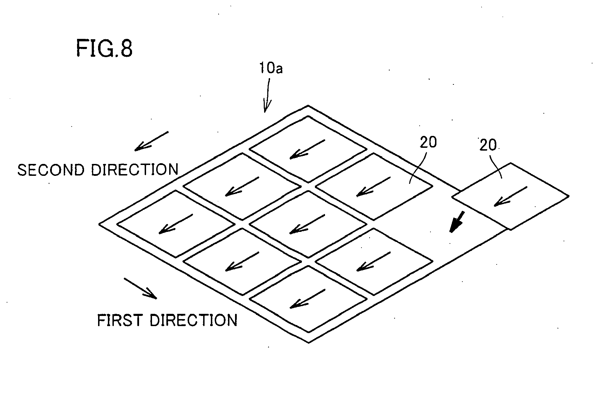

Fig. 8 shows a schematic perspective view illustrating one example of a manufacturing method for wiring sheet-equipped solar cells 100 shown in Fig. 1. Here, wiring sheet-equipped solar cells 100 shown in Fig. 1 can be fabricated by installing back surface electrode type solar cells 20 on the front surface of wiring sheet 10 having the configuration shown in Fig. 2, as shown in Fig. 8. In a case where the wiring sheet in accordance with the present invention is used, in the fabrication of the wiring sheet-equipped solar cells, it is possible to arrange cells in which back surface electrodes have the same arrangement by aligning them as indicated by arrows in Fig. 8, as back surface electrode type solar cells 20 adjacent to each other in the second direction and the first direction in a wiring sheet 10a constituting the wiring sheet-equipped solar cells as shown in Fig. 8. It is preferable in terms of manufacturing efficiency that back surface electrodes of back surface electrode type solar cells 20 have the same arrangement in the entire wiring sheet. The wiring sheet in accordance with the present invention that enables such an arrangement will be described below.

### (Wiring Sheet)

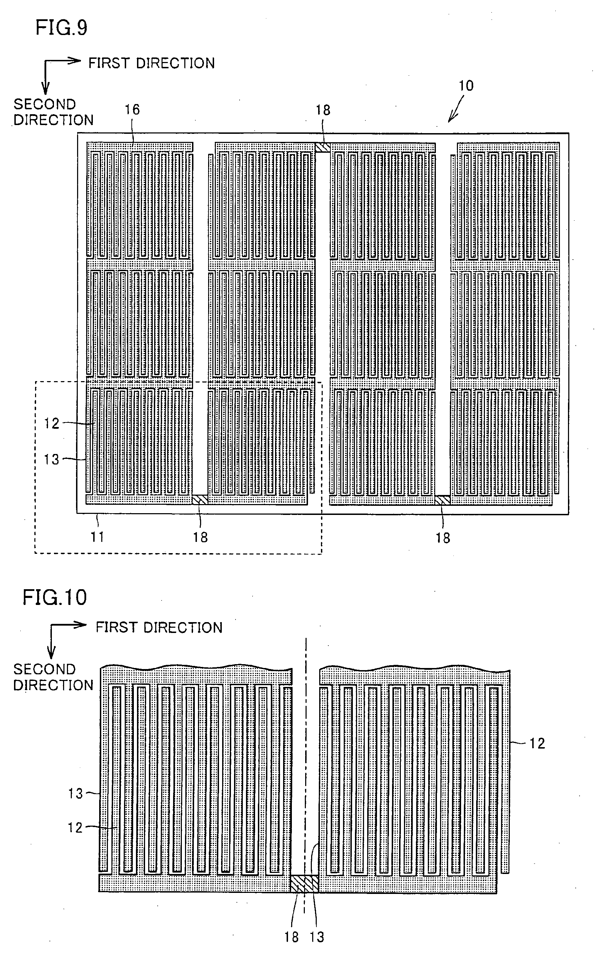

Fig. 9 shows a schematic plan view of a shape of the wiring materials of the wiring sheet in accordance with the present embodiment. Here, wiring sheet 10 has insulating base material 11, and wiring materials 16 installed on the front surface of insulating base material 11.

The wirings made of wiring materials 16 in accordance with the present invention include the first conductivity type wiring 12 and the second conductivity type wiring 13 insulated from each other in each cell arrangement portion. The first conductivity type wiring 12 is a wiring to which the first conductivity type electrodes of the back surface electrode type solar cell described later are to be connected, and the second conductivity type wiring 13 is a wiring to which the second conductivity type electrodes thereof are to be connected. In the present invention, the alternate alignment portion in which the first conductivity type wiring 12 and the second conductivity type wiring 13 are alternately aligned along the first direction is included. In Fig. 9, there is formed the alternate alignment portion in which the portions equivalent to the comb teeth of the first conductivity type wiring 12 and the portions equivalent to the comb teeth of the second conductivity type wiring 13 are alternately arranged, one by one, with a predetermined interval provided therebetween. Further, in the present invention, the first conductivity type wiring 12 is arranged at one of both ends of the alternate alignment portion along the first direction and the second conductivity type wiring 13 is arranged at the other end.

Here, wiring materials 16 constituting the respective cell arrangement portions aligned along the first direction are electrically connected with wiring materials 16 constituting the cell arrangement portions aligned adjacent thereto in the second direction in the front surface of insulating base material 11. In Fig. 9, the cell arrangement portions each made of a combination of one first conductivity type wiring 12 and one second conductivity type wiring 13 described above are arranged in three rows and four columns. The cell arrangement portion described above refers to a wiring portion made of a combination of the first conductivity type wiring 12 and the second conductivity type wiring 13 to which an electrode pattern of one back surface electrode type solar cell is to be connected.

In the present invention, a cell arrangement portion located at at least one end of the cell arrangement portions at both ends of wiring sheet 10 described above in the second direction and a cell arrangement portion corresponding to a back surface electrode type solar cell adjacent to the above cell arrangement portion in the first direction have a pattern that the second conductivity type wiring corresponding to one back surface electrode type solar cell and the first conductivity type wiring corresponding to the other back surface electrode type solar cell located adjacent to each other in the first direction are electrically connected, that is, a pattern that the wirings located adjacent to each other in the first direction have different conductivity types, and one of combinations of the wirings having different conductivity types is electrically connected. The pattern will be described below in detail.

Fig. 10 shows a schematic plan view enlarging a portion of the wiring materials corresponding to the cell arrangement portions at an end of the wiring sheet shown in Fig. 9 in the second direction. That is, Fig. 10 is a schematic plan view of a pattern portion equivalent to a portion surrounded by a dashed line in wiring materials 16 of wiring sheet 10 shown in Fig. 9, in which the wirings which correspond to two back surface electrode type solar cells adjacent to each other in the first direction and which are divided by an alternate long and short dash line are electrically connected. In Fig. 10, the wirings which correspond to the two back surface electrode type solar cells adjacent to each other in the first direction each have a pattern that the second conductivity type wiring 13 is arranged at a position corresponding to the second conductivity type electrode of the solar cell at the left end when facing toward Fig. 10, and the first conductivity type wiring 12 is arranged at the right end when facing toward Fig. 10. Further, in the wirings which correspond to the two back surface electrode type solar cells adjacent to each other in the first direction described above, the second conductivity type wiring 13 extending in the second direction to correspond to the second conductivity type electrodes of one back surface electrode type solar cell and the first conductivity type wiring 12 extending in the second direction to correspond to the first conductivity type electrodes of the other back surface electrode type solar cell are provided to be adjacent to each other.

In other words, the wirings have a pattern that the second conductivity type wiring 13 provided at a position corresponding to the second conductivity type electrodes of a back surface electrode type solar cell arranged at an odd-numbered location from one end of the above wiring sheet in the first direction and the first conductivity type wiring 12 provided at a position corresponding to the first conductivity type electrodes of a back surface electrode type solar cell arranged at an even-numbered location from the above one end are provided to be adjacent to each other, and these wirings are electrically connected.

In order to connect the solar cells adjacent to each other in the first direction in series in the wiring sheet having a wiring shape described above, it is only necessary to join the second conductivity type wiring to the first conductivity type wiring by a wiring or by a connecting portion 18 as shown in Figs. 9 and 10. In this case, since the wirings to be connected are adjacent as shown in Figs. 9 and 10, power loss due to wiring is extremely low, and thus output efficiency can be improved.

In a case where back surface electrode type solar cells 20 having a shape of the back surface of semiconductor substrate 21 shown in Fig. 4(a) are arranged on the wiring sheet in which the wirings in the first direction have the configuration shown in Fig. 10 described above, since the electrode of each solar cell at the left end when facing toward Fig. 4(a) is the first conductivity type electrode 24 and the electrode of each solar cell at the right end is the second conductivity type electrode 25, adjacent back surface electrode type solar cells 20 can be arranged by aligning cells having the same arrangement of back surface electrodes as shown in Fig. 8. Further, in the wiring sheet in accordance with the present invention, the back surface electrodes of the back surface electrode type solar cells can be arranged in the same manner in the entire wiring sheet. Here, for example, in a case where two solar cells adjacent to each other in the first direction are provided such that the second conductivity type wiring of one solar cell and the first conductivity type wiring of the other solar cell are not adjacent to each other, and the second conductivity type wirings are adjacent to each other, in order to connect the solar cells adjacent to each other in the first direction in series, it is necessary to turn over (or rotate) the solar cell with directions of front and back surfaces thereof being maintained, to match arrangement of the back surface electrodes of the solar cell to the wirings of the wiring sheet. In contrast, if the back surface electrodes of the back surface electrode type solar cells arranged as described above are arranged in the same manner in the wiring sheet, there is no need to turn over (or rotate) the solar cell as described above. Therefore, it becomes possible to arrange solar cells in one direction and connect all of them in series in a process of manufacturing a solar cell module, which can improve manufacturing efficiency.

If the first conductivity type electrodes and the second conductivity type electrodes on the back surface of the back surface electrode type solar cell are alternately aligned and both ends of the alignment have different conductivity types, and an electrode pattern including the first conductivity type electrodes and the second conductivity type electrodes has a shape that is line symmetrical with respect to an axis orthogonal to the direction in which the first conductivity type electrodes and the second conductivity type electrodes are alternately aligned, arrangement patterns of the wiring materials including the cell arrangement portions in columns adjacent to each other in the first direction can be formed as mirror images.

For example, if the arrangement and shape of the first conductivity type electrodes and the second conductivity type electrodes on the back surface of the back surface electrode type solar cell are formed such that the interval between the first conductivity type electrode and the second conductivity type electrode is equal as shown in Fig. 4(b), the left arrangement pattern of the wiring materials and the right arrangement pattern of the wiring materials in the arrangement patterns of the wiring materials shown in Fig. 10 can be formed as mirror images. By employing such a wiring pattern, for example, the arrangement patterns of the wiring materials can be formed merely by turning over a photomask for photo etching, without preparing two types of photomasks for the respective columns. Further, since it is only necessary to produce one type of data for the photomask, manufacturing efficiency can be further improved.

Further, in the wiring sheet in accordance with Embodiment 1, the wirings corresponding to the electrodes of adjacent back surface electrode type solar cells have a pattern that the second conductivity type wiring and the first conductivity type wiring are adjacent to each other both in the second direction and in the first direction. Thus, a distance between the second conductivity type wiring and the first conductivity type wiring adjacent to each other can be reduced when compared with a case where wirings of the same conductivity type are adjacent to each other. In a case where the distance between the wirings can be reduced in this manner, a potential difference between the wirings (i.e., between the electrodes of the solar cells corresponding to the respective electrodes) can be reduced by, for example, 0.5 V, depending on the standard for the cells. It is to be noted that, in the case where wirings of the same conductivity type are adjacent to each other, there is a potential difference between these wirings, and thus it is necessary to increase a distance between the wirings to prevent contact of the wirings and a short circuit between the wirings. Accordingly, there is not a little power loss due to the distance.

By reducing the distance between the wirings as described above, the area of wiring sheet-equipped solar cells in which the same number of solar cells are aligned can be reduced when compared with the case where wirings of the same conductivity type are adjacent to each other. Further, since the number of solar cells that can be aligned in the same area is increased, a higher output can be obtained.

Here, as a material for insulating base material 11, any material can be used without particular limitation as long as it has electrical insulating properties. For example, a material including at least one type of resin selected from the group consisting of polyethylene terephthalate (PET), polyethylene naphthalate (PEN), polyphenylene sulfide (PPS), polyvinyl fluoride (PVF), and polyimide can be used.

Further, the thickness of insulating base material 11 is not particularly limited, and can be set to, for example, not less than 10 µm and not more than 200 µm. It is to be noted that insulating base material 11 may have a single-layer structure composed of only one layer, or a multi-layer structure composed of two or more layers.

As a material for the first conductivity type wiring 12 and the second conductivity type wiring 13, any material can be used without particular limitation as long as it has electrically conductive properties. For example, a metal including at least one selected from the group consisting of copper, aluminum, and silver, or the like can be used.

Further, the thicknesses of the first conductivity type wiring 12 and the second conductivity type wiring 13 are not particularly limited either, and can be set to, for example, not less than 5 µm and not more than 75 µm.

Furthermore, it is needless to say that the shapes of the first conductivity type wiring 12 and the second conductivity type wiring 13 are not limited to the shapes described above as long as they satisfy the arrangement relation between the first conductivity type wiring and the second conductivity type wiring between adjacent columns as described above, and can be set as appropriate.

Further, for example, an electrically conductive material including at least one selected from the group consisting of nickel (Ni), gold (Au), platinum (Pt), palladium (Pd), silver (Ag), tin (Sn), SnPb solder, and indium tin oxide (ITO) may be installed on at least a portion of a surface of the first conductivity type wiring 12 and/or at least a portion of a surface of the second conductivity type wiring 13. In this case, there are tendencies that a good electrical connection can be established between the first conductivity type wiring 12 and the second conductivity type wiring 13 and the electrodes of back surface electrode type solar cell 20 described later, and that weather resistance of the first conductivity type wiring 12 and/or the second conductivity type wiring 13 can be improved.

Furthermore, at least a portion of the surface of the first conductivity type wiring 12 and/or at least a portion of the surface of the second conductivity type wiring 13 may be subjected to surface treatment such as blackening treatment.

It is to be noted that each of the first conductivity type wiring 12 and the second conductivity type wiring 13 may also have a single-layer structure composed of only one layer, or a multi-layer structure composed of two or more layers.

Hereinafter, one example of a manufacturing method for wiring sheet 10 having a configuration shown in Fig. 9 will be described. Firstly, insulating base material 11 such as a PET film is prepared, and an electrically conductive material such as metal foil or a metal plate is attached to an entire surface of insulating base material 11.

Next, a portion of the electrically conductive material attached to the surface of insulating base material 11 is removed by photoetching or the like. Thereby, the electrically conductive material is patterned, and wiring materials 16 composed of the first conductivity type wirings 12 and the second conductivity type wirings 13 made of the patterned electrically conductive material are formed on the surface of insulating base material 11. Thus, wiring sheet 10 having the configuration shown in Fig. 9 can be fabricated.

If the above wiring sheet includes connecting portion 18, any material can be used without particular limitation as a material for connecting portion 18, as long as it has electrically conductive properties. For example, a metal including at least one selected from the group consisting of copper, aluminum, and silver, or the like can be used.

Further, the thickness of connecting portion 18 is not particularly limited either, and can be set to, for example, not less than 5 µm and not more than 75 µm.

Furthermore, it is needless to say that the shape of connecting portion 18 is not limited to the shape described above, and can be set as appropriate.

Further, for example, an electrically conductive material including at least one selected from the group consisting of nickel (Ni), gold (Au), platinum (Pt), palladium (Pd), silver (Ag), tin (Sn), SnPb solder, and indium tin oxide (ITO) may also be installed on at least a portion of a surface of connecting portion 18. In this case, there are tendencies that a good electrical connection can be established by connecting portion 18, and that weather resistance of connecting portion 18 can be improved.

Furthermore, at least a portion of the surface of connecting portion 18 may also be subjected to surface treatment such as blackening treatment. In addition, connecting portion 18 may have a single-layer structure composed of only one layer, or a multi-layer structure composed of two or more layers.

It is to be noted that the method of forming connecting portion 18 is not particularly limited as long as it can form connecting portion 18 which electrically connects the first conductivity type wiring 12 and the second conductivity type wiring 13 adjacent to each other. Further, connecting portion 18 may be formed separately from wiring materials 16 such as the first conductivity type wiring 12 and the second conductivity type wiring 13, or may be formed integrally with wiring materials 16.

As described above, the wiring sheet-equipped solar cells having a configuration shown for example in Fig. 1 are fabricated by electrically connecting the back surface electrode type solar cells using the wiring sheet in accordance with the present invention. In wiring sheet-equipped solar cells 100, back surface electrode type solar cells 20 are electrically connected in series on the front surface of insulating base material 11.

### (Solar Cell Module)

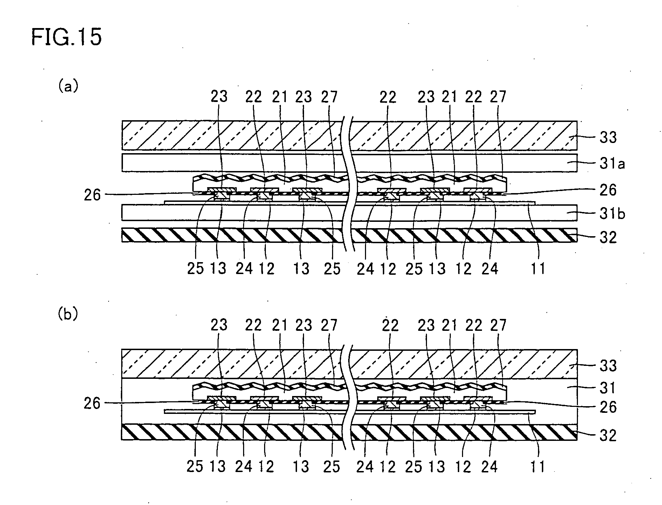

Figs. 15(a) and 15(b) show schematic cross sectional views illustrating one example of a manufacturing method for one example of a solar cell module in accordance with the present invention. Hereinafter, one example of the manufacturing method for one example of the solar cell module in accordance with the present invention using the wiring sheet-equipped solar cells fabricated as described above will be described with reference to Figs. 15(a) and 15(b).

Firstly, as shown in Fig. 15(a), a transparent substrate 33 provided with a first transparent resin 31a is installed on a back surface electrode type solar cells side of the wiring sheet-equipped solar cells, and a back surface protective sheet 32 provided with a second transparent resin 31b is installed on a wiring sheet side of the wiring sheet-equipped solar cells. Here, as the wiring sheet-equipped solar cells, wiring sheet-equipped solar cells fabricated by electrically connecting a plurality of solar cells as described above may be used, and wiring sheet-equipped solar cells fabricated by electrically connecting a plurality of divided wiring sheet-equipped solar cells may also be used.

Next, heat treatment is performed, with the first transparent resin 31a being pressure-bonded to the back surface electrode type solar cells of the wiring sheet-equipped solar cells and with the second transparent resin 31b being pressure-bonded to the wiring sheet of the wiring sheet-equipped solar cells. Thus, the first transparent resin 31a and the second transparent resin 31b are integrally cured. Thereby, one example of the solar cell module in accordance with the present invention formed by sealing the above wiring sheet-equipped solar cells in a sealing material 31 formed by integrating the first transparent resin 31a and the second transparent resin 31b is fabricated as shown in Fig. 15(b).

In the solar cell module shown in Fig. 15(b), the back surface electrode type solar cells are securely pressure-bonded to the wiring sheet by stretching force of sealing material 31, and thereby pressure bonding between the first conductivity type electrodes 24 of the back surface electrode type solar cells and the first conductivity type wirings 12 of the wiring sheet and pressure bonding between the second conductivity type electrodes 25 of the back surface electrode type solar cells and the second conductivity type wirings 13 of the wiring sheet are each strengthened, achieving a good electrical connection between the electrodes of the respective back surface electrode type solar cells and the wirings of the wiring sheet.

Here, pressure bonding and heat treatment for sealing the wiring sheet-equipped solar cells in sealing material 31 can be performed using, for example, an apparatus called laminator performing vacuum pressure bonding and heat treatment, or the like. By thermally deforming and thermally curing the first transparent resin 31a and the second transparent resin 31b using, for example, a laminator, these transparent resins are integrated to form sealing material 31, and the above wiring sheet-equipped solar cells are sealed in sealing material 31 to be enclosed therein.

It is to be noted that vacuum pressure bonding refers to treatment of performing pressure bonding under an atmosphere having a pressure lower than the atmospheric pressure. If vacuum pressure bonding is used as a pressure bonding method, it is preferable in that a gap is less likely to be formed between the first transparent resin 31a and the second transparent resin 31b, and in that there is a tendency that air bubbles are less likely to remain in sealing material 31 formed by integrating the first transparent resin 31a and the second transparent resin 31b. Further, there is also a tendency that using vacuum pressure bonding is advantageous for ensuring uniform pressure bonding force between the back surface electrode type solar cells and the wiring sheet.

Here, as transparent substrate 33, any substrate can be used without particular limitation as long as it is transparent to sunlight. For example, a glass substrate or the like can be used.

Further, as the first transparent resin 31a and the second transparent resin 31b, any resin that is transparent to sunlight can be used without particular limitation. It is particularly preferable to use at least one type of transparent resin selected from the group consisting of ethylene vinyl acetate resin, epoxy resin, acrylic resin, urethane resin, olefin-based resin, polyester resin, silicone resin, polystyrene resin, polycarbonate resin, and rubber-based resin. In this case, since sealing material 31 is excellent in weather resistance and has high sunlight transmission properties, sealing material 31 can be fixed to transparent substrate 33 with a sufficient strength, without significant loss of an output of the solar cell module (in particular, short-circuit current or current in operation). Thereby, there is a tendency that long-time reliability of the solar cell module can be ensured.

It is to be noted that the first transparent resin 31a and the second transparent resin 31b may be made of the same type of transparent resin, or may be made of different types of transparent resins.

Further, if the first transparent resin 31a and the second transparent resin 3 1 b are each made of, for example, ethylene vinyl acetate resin, the heat treatment when sealing the above wiring sheet-equipped solar cells in sealing material 31 can be performed by heating each of the first transparent resin 31a and the second transparent resin 31b to a temperature of, for example, not less than 100°C and not more than 200°C.

Further, as back surface protective sheet 32, any sheet can be used without particular limitation as long as it can protect a back surface of sealing material 31. For example, a conventionally-used weather-resistant film such as PET can be used.

Furthermore, from the viewpoint of sufficiently suppressing permeation of water vapor and oxygen into sealing material 31 and ensuring long-time reliability, back surface protective sheet 32 may include a film made of a metal such as aluminum.

In addition, at a portion such as an end surface of the solar cell module where it is difficult to closely attach back surface protective sheet 32, a moisture permeation preventing tape such as a butyl rubber tape can be used to completely attach back surface protective sheet 32 to the portion.

Further, a frame made of such as an aluminum alloy may be attached to surround the outer periphery of the solar cell module.

It is needless to say that each of the wiring sheet, the wiring sheet-equipped solar cells, and the solar cell module in accordance with the present invention is not limited to the configuration described above, and can have various configurations.

Although a case where electrical connection between the solar cells and the wiring sheet is all series connection in each of the wiring sheet-equipped solar cells and the solar cell module in accordance with the present invention has been described, the electrical connection may be series connection, parallel connection, or a combination of series connection and parallel connection.

Further, the first conductivity type may be defined as n type and the second conductivity type may be defined as p type, or the first conductivity type may be defined as p type and the second conductivity type may be defined as n type. In the above description regarding the wiring sheet, the first conductivity type wiring 12 provided at a position corresponding to the first conductivity type electrodes of a back surface electrode type solar cell at an odd-numbered location from one end of the wiring sheet in the first direction and the second conductivity type wiring 13 provided at a position corresponding to the second conductivity type electrodes of a back surface electrode type solar cell arranged at an even-numbered location from the same end may be provided to be adjacent to each other.

As an example in which the back surface electrode type solar cells are aligned in a matrix, the present embodiment has described a case where the back surface electrode type solar cells are aligned such that the first direction (row direction) and the second direction (column direction) are orthogonal to each other as shown in Fig. 9 and the like, that is, the back surface electrode type solar cells are aligned in a square lattice. However, the present embodiment may include a case where an adjacent row or column is misaligned for example by half a pitch in the first direction or the second direction with respect to the alignment in the square lattice, and a case where both a row and a column are misaligned.

### (Function)

As described above, in the present invention, since the wirings corresponding to the back surface electrode type solar cells adjacent to each other in the first direction in the cell arrangement portions at an end of the wiring sheet has a pattern of electrically connecting the second conductivity type wiring corresponding to one back surface electrode type solar cell and the first conductivity type wiring corresponding to the other back surface electrode type solar cell, the wiring sheet-equipped solar cells can be fabricated by aligning a plurality of back surface electrode type solar cells having the same arrangement of back surface electrodes on the wiring sheet as shown in Fig. 8 and electrically connecting them.

Therefore, in manufacturing the solar cell module, orientations of the back surface electrode type solar cells can be maintained in one direction, and a process of changing orientations such as rotating the solar cells to match the wiring sheet is not included. Accordingly, manufacturing efficiency of the solar cell module can be improved.

Further, in the present invention, since the wirings adjacent in the first direction in a portion of cells of the wiring sheet corresponding to the back surface electrode type solar cells have different conductivity types, it is possible to reduce a potential difference between the electrodes of two back surface electrode type solar cells adjacent in the first direction or between the wirings by, for example, 0.5 V, when compared with the case where wirings of the same conductivity type are adjacent to each other. Therefore, in the present invention, the solar cell module having a large-area light-receiving surface can be fabricated by minutely forming each interval between the second conductivity type wiring and the first conductivity type wiring of the wiring sheet and suppressing a short circuit between the second conductivity type wiring and the first conductivity type wiring.

Furthermore, in the present invention, since the potential difference between the electrodes of two adjacent back surface electrode type solar cells or between the wirings is reduced as described above, it is possible to reduce a width between the electrodes and a width between the wirings in the first direction when compared with the case where wirings of the same conductivity type are adjacent to each other. As a result, the total area of the solar cell module can be reduced.

### <Embodiment 2>

The present embodiment is identical to Embodiment 1 except that the second conductivity type wiring and the first conductivity type wiring corresponding to two back surface electrode type solar cells adjacent to each other in the first direction are entirely connected along the second direction, and the description overlapping with the description in Embodiment 1 will be omitted.

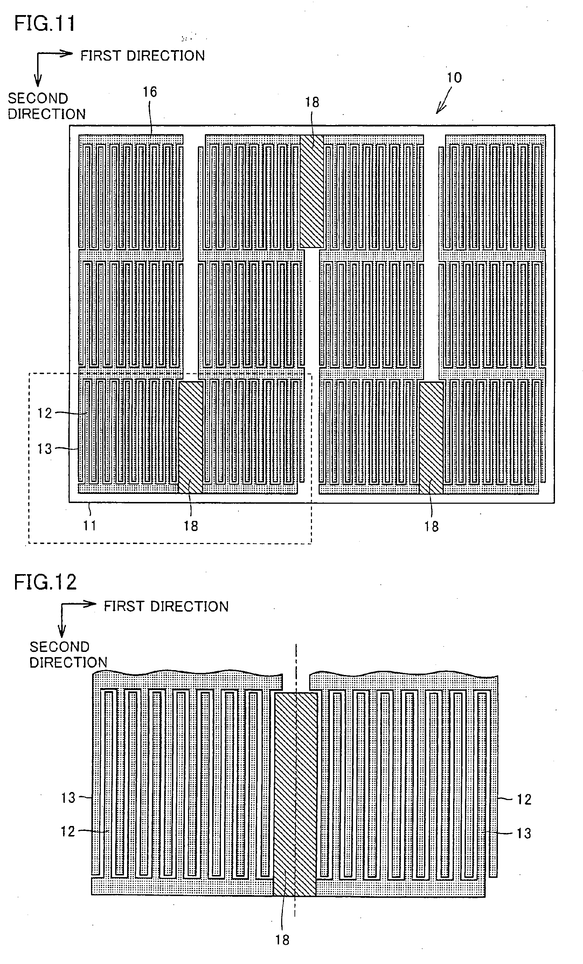

Fig. 11 shows a schematic plan view of a shape of wiring materials of a wiring sheet in accordance with Embodiment 2. Fig. 12 shows a schematic plan view enlarging a portion of the wiring materials of the wiring sheet shown in Fig. 11.

In the present invention, the wirings corresponding to two back surface electrode type solar cells adjacent to each other in the first direction are arranged such that the second conductivity type wiring 13 corresponding to the second conductivity type electrodes of one back surface electrode type solar cell and the first conductivity type wiring 12 corresponding to the first conductivity type electrodes of the other back surface electrode type solar cell are adjacent to each other. In Embodiment 2, the wirings have a pattern that these adjacent wirings are entirely connected along the second direction. Although it is satisfactory in the present invention as long as at least a portion of the adjacent wirings is connected as in Embodiment 1 described above, entirely connecting the adjacent wirings along the second direction increases a contact area, and is advantageous in terms of contact efficiency.

It is to be noted that, although connecting portion 18, the first conductivity type electrodes corresponding to one back surface electrode type solar cell, and the second conductivity type electrodes corresponding to the other back surface electrode type solar cell are integrated in Fig. 12, the effect of the present invention can also be exhibited even when connecting portion 18 is provided separately from the first conductivity type electrodes and the second conductivity type electrodes described above.

### <Embodiment 3>

The present embodiment is **characterized in that** wirings corresponding to two back surface electrode type solar cells adjacent to each other in the first direction are provided such that the first conductivity type wiring 12 corresponding to the first conductivity type electrodes of one back surface electrode type solar cell and the second conductivity type wiring 13 corresponding to the second conductivity type electrodes of the other back surface electrode type solar cell are adjacent to each other, and conductivity type electrodes different from these adjacent wirings are connected.

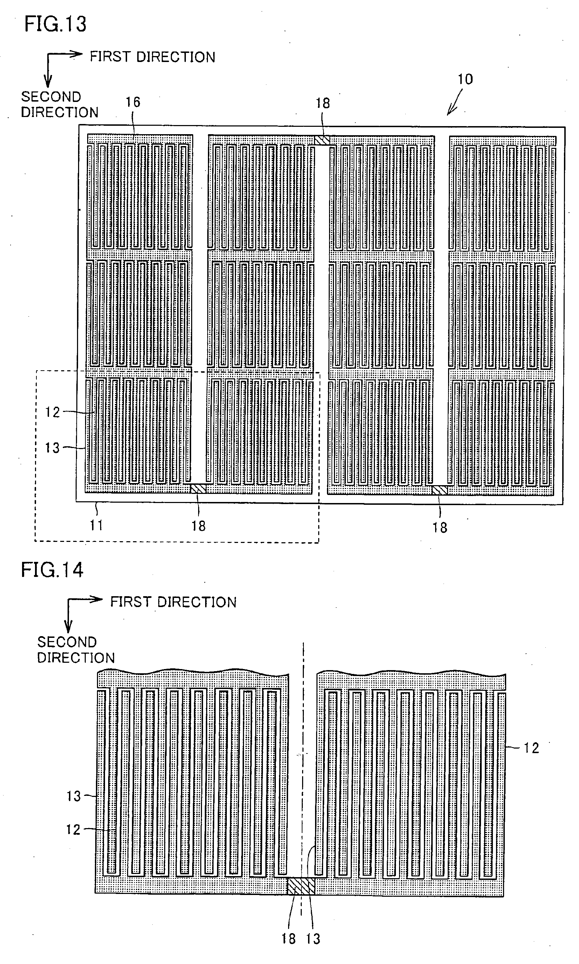

Fig. 13 shows a schematic plan view of a shape of wiring materials of a wiring sheet in accordance with Embodiment 2. Fig. 14 shows a schematic plan view enlarging a portion of the wiring materials of the wiring sheet shown in Fig. 13.

Specifically, the second conductivity type wiring 13 corresponding to the second conductivity type electrodes of one back surface electrode type solar cell may be connected to the first conductivity type wiring 12 corresponding to the first conductivity type electrodes of the other back surface electrode type solar cell, as shown in Figs. 13 and 14. Thus, even though the adjacent wirings are not connected, the solar cells having an identical electrode pattern can be always aligned in a constant direction in the process of manufacturing the solar cell module, as in other embodiments. Therefore, degrees of freedom in designing the electrode pattern of the back surface electrode type solar cell and the arrangement pattern of the wiring materials of the wiring sheet can be enhanced.

It is to be noted that, although connecting portion 18, the first conductivity type electrodes corresponding to one back surface electrode type solar cell, and the second conductivity type electrodes corresponding to the other back surface electrode type solar cell are integrated in Fig. 13, the effect of the present invention can also be exhibited even when connecting portion 18 is provided separately from the first conductivity type electrodes and the second conductivity type electrodes described above.

Although the embodiments of the present invention have been described above, it is originally intended to combine the configurations of the embodiments described above as appropriate.

It should be understood that the embodiments disclosed herein are illustrative and non-restrictive in every respect. The scope of the present invention is defined by the scope of the claims, rather than the description above, and is intended to include any modifications within the scope and meaning equivalent to the scope of the claims.

### INDUSTRIAL APPLICABILITY

According to the present invention, a wiring sheet capable of improving output efficiency and manufacturing efficiency of a solar cell module, and a solar cell module can be provided.

### REFERENCE SIGNS LIST

10, 10a: wiring sheet, 11: insulating base material, 12: the first conductivity type wiring, 13: the second conductivity type wiring, 16: wiring material, 18: connecting portion, 19: cell arrangement portion, 20: back surface electrode type solar cell, 21: semiconductor substrate, 22: the first conductivity type impurities-diffused region, 23: the second conductivity type impurities-diffused region, 24: the first conductivity type electrode, 25: the second conductivity type electrode, 26: passivation film, 27: anti-reflection film, 31: sealing material, 31a: the first transparent resin, 31b: the second transparent resin, 32: back surface protective sheet, 33: transparent substrate, 51: upper transparent protective material, 52: filling adhesive sheet, 53: interconnector, 54: solar cell, 55: lower substrate protective material, 57a, 57b: opposite side portion, 100: wiring sheet-equipped solar cells.

## Claims

1. A wiring sheet (10) having wirings provided on an insulating base material (11) for electrically connecting back surface electrode type solar cells (20) each having first conductivity type electrodes (24) and second conductivity type electrodes (25) arranged on one surface of a semiconductor substrate (21), wherein
said wirings have a cell arrangement portion (19) on which the back surface electrode type solar cell (20) is to be arranged, and a plurality of the cell arrangement portions (19) are aligned on said insulating base material (11) in a first direction and in a second direction different from the first direction,
each of said cell arrangement portions (19) includes an alternate alignment portion in which a first conductivity type wiring (12) for the first conductivity type electrodes (24) and a second conductivity type wiring (13) for the second conductivity type electrodes (25) electrically insulated from each other are alternately aligned along said first direction, and the first conductivity type wiring (12) is arranged at one of both ends of the alternate alignment portion in said first direction and the second conductivity type wiring (13) is arranged at the other end,
the first conductivity type wiring (12) in one of the cell arrangement portions (19) adj acent to each other in said second direction on said insulating base material (11) is electrically connected with the second conductivity type wiring (13) in the other cell arrangement portion (19), and
the cell arrangement portion (19) located at at least one of both ends of the cell arrangement portions (19) aligned in said second direction on said insulating base material (11) and the cell arrangement portion (19) adjacent to that cell arrangement portion (19) in said first direction are arranged such that the first conductivity type wiring (12) in one cell arrangement portion (19) and the second conductivity type wiring (13) in the other cell arrangement portion (19) are adjacent to each other in said first direction, and one of combinations of the wirings having different conductivity types is electrically connected between said one cell arrangement portion (19) and said other cell arrangement portion (19).

2. The wiring sheet (10) according to claim 1, having the back surface electrode type solar cells (20) electrically connected thereto.

3. A solar cell module, comprising the wiring sheet (10) according to claim 1 or 2.

4. Wiring sheet-equipped solar cells (100), comprising:
back surface electrode type solar cells (20) each having first conductivity type electrodes (24) and second conductivity type electrodes (25) arranged on one surface of a semiconductor substrate (21); and
a wiring sheet (10) having wirings provided on an insulating base material (11) for electrically connecting the back surface electrode type solar cells (20), wherein
said back surface electrode type solar cells (20) are aligned on said wiring sheet (10) in a first direction and in a second direction different from the first direction,
said wirings include an alternate alignment portion in which a first conductivity type wiring (12) electrically connected to said first conductivity type electrodes (24) and a second conductivity type wiring (13) electrically connected to said second conductivity type electrodes (25) of said back surface electrode type solar cell (20) are alternately aligned along said first direction corresponding to each of said back surface electrode type solar cells (20),
said first conductivity type wiring (12) is arranged at one of both ends of the alternate alignment portion in said first direction and said second conductivity type wiring (13) is arranged at the other end,
the first conductivity type wiring (12) connected to the first conductivity type electrodes (24) of one of the back surface electrode type solar cells (20) adjacent to each other in said second direction is electrically connected with the second conductivity type wiring (13) connected to the second conductivity type electrodes (25) of the other back surface electrode type solar cell (20), and
in the wirings to which the back surface electrode type solar cell (20) located at at least one of both ends in said second direction is connected and the wirings connected to the electrodes of the back surface electrode type solar cell (20) adjacent to that back surface electrode type solar cell (20) in said first direction, the wirings adjacent to each other in said first direction have different conductivity types, and one of combinations of the wirings having different conductivity types is electrically connected.

5. A solar cell module, comprising the wiring sheet-equipped solar cells (100) according to claim 4.
